# EUROPEAN PATENT SPECIFICATION

(11) **EP 1 096 671 B1**
(45) Date of publication and mention of the grant of the patent: **29.04.2009**
(21) Application number: 00309405.9
(22) Date of filing: 25.10.2000
(51) Int. Cl.: H03F 3/45

(54) **A differential operational amplifier**
Differenzoperationsverstärker
Amplificateur opérationnel différentiel

(30) Priority: 25.10.1999 US 161282 P; 06.09.2000 US 655697
(43) Date of publication of application: 02.05.2001
(73) Proprietor: Texas Instruments Incorporated, Dallas, Texas 75251 (US)
(72) Inventor: Nagaraj, Krishnasawamy, Sommerville, New Jersey 08876 (US)
(74) Representative: Legg, Cyrus James Grahame

(56) References cited:
- US-A- 4 656 436
- US-A- 5 914 638
- ADACHI T ET AL: "A LOW NOISE INTEGRATED AMPS IF FILTER" PROCEEDINGS OF THE CUSTOM INTEGRATED CIRCUITS CONFERENCE,US,NEW YORK, IEEE, vol. CONF. 16, 1 May 1994 (1994-05-01), pages 159-162, XP000492875
- REZZI F ET AL: "A 3V PSEUDO-DIFFERENTIAL TRANSCONDUCTOR WITH INTRINSIC REJECTION OFTHE COMMON-MODE INPUT SIGNAL" PROCEEDINGS OF THE MIDWEST SYMPOSIUM ON CIRCUITS AND SYSTEMS,US,NEW YORK, IEEE, vol. SYMP. 37, 3 August 1994 (1994-08-03), pages 85-88, XP000531982 ISBN: 0-7803-2429-3

## Description

This invention relates to the field of electronic circuits associated with operational amplifiers (op-amps) and in particular to low-voltage versions of these circuits suitable for use in various pipelined analog-to-digital converter and/or other portable applications.

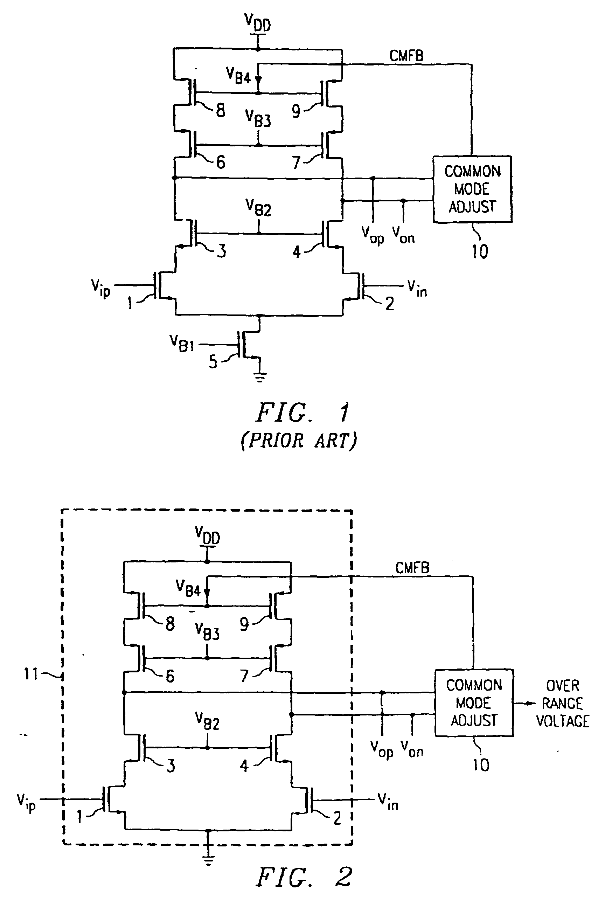

Figure 1 shows a schematic for the well known 'telescopic cascode' amplifier. A bandwidth of 500 MHz and a dc gain of 60 dB is achievable with this type circuit.
This differential op-amp is comprised of cascoded n-channel input transistors 1,3 and 2,4 at the Vᵢₚ and Vᵢₙ inputs, respectively, along with the long tail current source transistor 5. P-channel transistors 6-9 act as an active load. The common mode adjust circuitry 10 is used to compensate for a mismatch between tail current and the bias current by providing a common mode feedback (CMFB) signal to the gates of transistors 8 and 9. The differential outputs V_{Op} and V_{On} for the circuit are taken from the drains of n-channel transistors 3 and 4, respectively. Because this amplifier is known to have a minimum number of non-dominant poles, the circuit has excellent bandwidth properties. This is primarily due to the following:
1) the p-channel transistors 6-9 in the circuit do not carry any signal current. Thus, all capacitances associated with p-channel transistors 8 and 9, as well as the gate-source and source-substrate capacitances of p-channel transistors 6 and 7 do not contribute any poles;
2) since the main non-dominant poles are contributed by the n-channel transistors, which can be kept small in size by tailoring their W/L layout for a given transconductance, the resulting poles will generally be at higher frequencies;
3) the large capacitance often associated with a folded cascode amplifier, where three transistors have to 'meet' at the folding node, is not present in this telescopic cascode amplifier.

The main problem with this conventional cascode operational amplifier circuit is that of low voltage headroom. Because so many transistors are stacked, it is difficult to realize this circuit when working at voltages as low as 2.5 volts or less.

A number of patents may be of interest in relation to the technology discussed above and in this patent, including but not limited to the following:
U.S. Patent No. 5,798,673 Low voltage operational amplifier bias current and method.
U.S. Patent No. 5,734,296 Low voltage operational amplifier input stage and method.

Also the article REZZI F ET AL: "A 3V PSEUDO-DIFFERENTIAL TRANSCONDUCTOR WITH INTRINSIC REJECTION OF THE COMMON-MODE INPUT SIGNAL" PROCEEDINGS OF THE MIDWEST SYMPOSIUM ON CIRCUITS AND SYSTEMS,US, NEW YORK, IEEE, vol. SYMP. 37 discusses a related circuit.

The invention provides a differential operational amplifier for operation between a first and a second voltage supply, comprising:
a differential pair of cascoded input transistors including first input transistor gates for receiving first and second input signals,
cascoded active transistor loads for connecting output nodes of each of said input transistor cascodes to the second voltage supply, and
a common mode adjust circuit connected to adjust the currents in the active transistor loads in accordance with the common mode output signal from the output nodes of the differential pair of cascoded input transistors, wherein
in the operation of the amplifier, second input (source) nodes of said cascoded input transistors are coupled directly to the first voltage supply.

The long-tail current source is eliminated from a differential amplifier in accordance with the invention.

Preferably, the amplifier further includes a correction voltage generator (27) connected to the common mode adjust circuit (10) to adjust a common mode voltage of the first and second input signals (Vip, Vin).

Preferably, the amplifier includes field effect transistors in the differential pair of cascoded input transistors, the source terminals of the lower field effect transistors below the cascodes serving as the second input nodes and being, in operation, connected directly to the first voltage supply.

The amplifier is especially suitable for operation where the difference between the first voltage supply and second voltage supply is less than 2.5 volts.

Preferably, the amplifier comprises:
a first n-channel transistor including an input gate terminal for receiving a first input signal,
a second n-channel transistor including an input gate for receiving a second input signal,
the source terminals of said first and second n-channel transistors being connected together and, in operation, connected to the first voltage supply,
a third n-channel transistor including a source terminal to which the drain terminal of said first n-channel transistor is coupled,
a fourth n-channel transistor including a source terminal to which the drain of said second n-channel transistor is coupled,
the gate terminals of said third and fourth n-channel transistors being connected together and for receiving a first common mode control signal,
a first p-channel transistor including a drain terminal to which the drain terminal of said third n-channel transistor and a first input of said common mode adjust circuit are connected, the drain terminals of the transistors serving as a first differential signal output terminal,
a second p-channel transistor including a drain terminal to which the drain terminal of said fourth n-channel transistor and a second input of said common mode adjust circuit are connected, the drain terminals of the transistors serving as a second differential signal output terminal,
the gate terminals of said first and second p-channel transistors being connected together for receiving a second common mode control signal,
a third p-channel transistor including a drain terminal to which the source terminal of said first p-channel transistor is connected,
a fourth p-channel transistor including a drain terminal to which the source terminal of said second p-channel transistor is connected,
the gate terminals of said third and fourth p-channel transistors connected together for receiving a first output signal from said common mode adjust circuit,
the source terminals of said third and fourth p-channel connected together for connection to the second voltage supply and
a second output terminal of said common mode adjust circuit providing an over-range voltage output signal.

Preferably, the operational amplifier further comprises:
a correction voltage generator circuit and
a summing amplifier circuit together arranged to monitor the common mode output signal from the common mode adjust circuit and the amplifier being capable of:
   monitoring the common mode output signal,
   comparing the common mode output signal to a specified range around said amplifier's nominal bias current,
   generating an out-of-range error signal when the monitored output signal is above or below said specified range, and
   making with the correction voltage generator circuit and the summing amplifier circuit an appropriate correction to the operational amplifier's common mode input voltage when said specified range is exceeded.

Preferably, the amplifier includes:
an input terminal of said correction voltage generator is coupled to an output terminal of said common mode adjust circuit,
an output of said correction voltage generator is coupled to a first input of said summing amplifier,
a second input to said summing amplifier is coupled to a common mode voltage and
an output of said summing amplifier provides the corrected common mode input voltage to said amplifier.

Preferably, the amplifier includes an UP/DOWN counter, a digital-to-analog converter, and summing circuitry to develop a small correction current which is summed to the nominal amplifier bias current, further comprising:
an under range input voltage coupled to the input of an inverter;
the output of said inverter being coupled to the first input of an UP/DOWN counter;
an over range input voltage coupled to the second input of said UP/DOWN counter;
a clock signal coupled to the third input of said UP/DOWN counter;
the output of said UP/DOWN counter being coupled to the input of a digital-to-analog (D/A) converter;
the output of said D/A converter being coupled to the gate and drain of a n-channel transistor, to the output of a current source, and to the input common mode voltage output;
the input of said current source being coupled to the power supply voltage;
the source of said n-channel transistor being coupled to circuit ground.

The amplifier may include a charge pump circuit and a capacitor in place of the combination of said UP/DOWN counter and digital-to-analog converter.

Preferably, the amplifier is operable to replicate the current flowing in the input transistors of the main operational amplifier and generates UP and DOWN counter control signals by comparing replica currents to the upper and lower current limits, comprising:
a positive differential input signal coupled to the negative input of said operational amplifier of this patent and to the gates of a first and a second n-channel transistor;
a negative differential input signal coupled to the positive input of said operational amplifier and to the gates of a third and a fourth n-channel transistor;
the sources of said first and third n-channel transistors being connected together and coupled to circuit ground;
the sources of said second and fourth n-channel transistors being connected together and coupled to circuit ground;
the drains of said first and third n-channel transistors being connected together and coupled to the output of a first current source and to an under range voltage output;
the drains of said second and fourth n-channel transistors being connected together and coupled to the output of a second current source and to an over range voltage output;
the inputs to said first and second current sources being connected together and coupled to the power supply source.

The amplifier is preferably connected to a network of capacitors and switches in a switched capacitor amplifier.

Preferably, the switched capacitor amplifier further comprises:
said first differential input signal coupled to the input of a first phase 1 switch;
said second differential input signal coupled to the input of a second phase 1 switch;
the output of said first phase 1 switch coupled to the input of a first phase 2 switch and to the bottom plate of a first capacitor;
the output of said second phase 1 switch coupled to the input of a second phase 2 switch and to the bottom plate of a second capacitor;
the outputs of said first and second phase 1 switches connected together and coupled to the common mode output voltage;
the top plate of said first capacitor coupled to top plate of a third capacitor, to the input of a third phase 1 switch, and to the negative input of said operational amplifier;
the top plate of said second capacitor coupled to the top plate of a fourth capacitor, to the input of a fourth phase 1 switch, and to the positive input of said operational amplifier;
the outputs of said third and fourth phase 1 switches connected together and coupled to the input common mode voltage;
the bottom plate of said third capacitor coupled to input of a third phase 2 switch and to the input of a fifth phase 1 switch;
the bottom plate of said fourth capacitor coupled to input of a fourth phase 2 switch and to the input of a sixth phase 1 switch;
the output of said fifth and sixth phase 1 switches coupled to the output common mode voltage;
the positive differential output of said operational amplifier coupled to the output of said third phase 2 switch and to the first input of common mode adjust circuit;
the negative differential output of said operational amplifier coupled to the output of said fourth phase 2 switch and to the second input of said common mode adjust circuit;
the first output of said common mode adjust circuit coupled to the third input of said operational amplifier;
the second output of said common mode adjust circuit providing an over range voltage used for the common mode correction.

The invention provides method for operating an operational amplifier with common mode input correction voltage, comprising:
amplifiying a signal with a telescopic cascoded differential amplifier free of a long tail current source;
generating a common mode feedback signal;
monitoring the amount of current supplied to said operational amplifier by said common mode feedback signal;
generating a value of said common mode input correction voltage based on how much the said amount of current exceeds a nominal amplifier bias current.

The method may further comprise the steps of:
replicating the current flowing in the input transistors of the main operational amplifier and generates UP and DOWN counter control signals by comparing replica currents to the upper and lower current limits;
providing a corrected input common mode voltage using an UP/DOWN counter, a digital-to-analog converter, and summing circuitry to develop a small correction current which is summed to the nominal amplifier bias current.

A new differential, low voltage, broadband operational amplifier which eliminates the long tail current source from the amplifier, thereby relieving the low voltage headroom requirements, is disclosed. This advantage will allow the amplifier to operate from a power supply of less than 2.5 volts.

The circuitry of this invention compensates for the significant changes in drain current in the input transistors of the amplifier by monitoring the current in a common mode feedback signal. When the value of this current exceeds a specified range around the nominal amplifier bias current, an appropriate correction is made to the common mode input voltage. Using this circuitry which can be implemented with minimal chip area and negligible power consumption, an operational amplifier is built without a long tail current source that operates at voltages of 2.5 volts or less.

Two implementations for the control loop for common mode input voltage are discussed, although other implementations are possible. Simulated results for both a conventional amplifier and the operational amplifier of this invention, both running from a power supply of less than 2.5 volts, are compared.

The included drawings are as follows:
Figure 1 shows a circuit diagram for a conventional telescopic cascode operational amplifier. (prior art)
Figure 2 depicts the schematic for a first embodiment of the modified telescopic cascode operational amplifier of this invention.
Figures 3a and 3b is the schematic and clock cycle, respectively, for a typical switched capacitor amplifier using the operational amplifier of Figure 2.
Figures 4a and 4b are block diagrams for the common mode input voltage correction technique used with the operational amplifier of this invention in both (a) the switched capacitor and (b) other general applications.
Figures 5a, 5b, and 5c are schematic diagrams for a first implementation of the common mode voltage correction technique of Figure 4.
Figure 6 is a schematic diagram for a second implementation of the common mode input voltage correction technique of Figure 4.
Figure 7 compares simulation results for the operational amplifier of this invention and for a conventional cascode operational amplifier, both running from a 2.5 volt power supply.

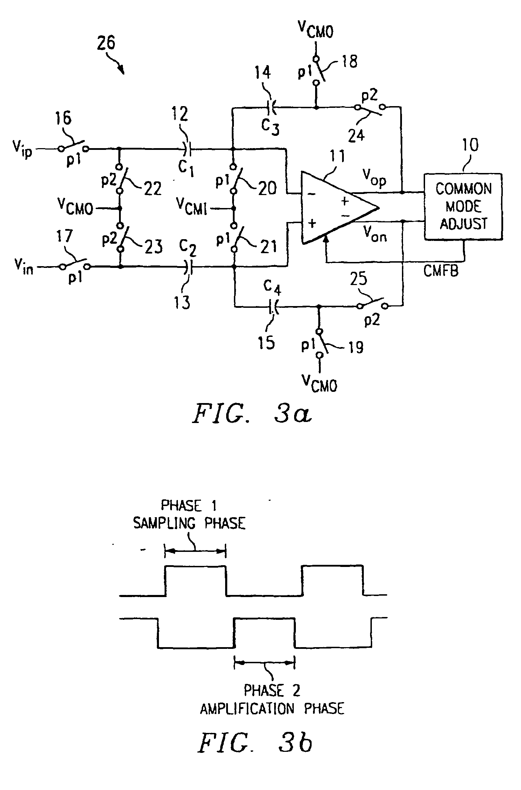

Figure 2 is a schematic for a first embodiment of the modified operational amplifier circuit 11 with common mode adjust circuitry 10, which addresses the low voltage headroom problem discussed in the earlier prior art discussion. Here, the long tail current source 5 (in Figure 1) has been eliminated completely, taking away the common mode rejection properties of the amplifier. As in Figure 1, this differential op-amp is comprised of cascoded n-channel input transistors 1,3 and 2,4 at the Vᵢₚ and Vᵢₙ inputs, respectively, but with the long tail current source transistor 5 (Figure 1) eliminated. P-channel transistors 6-9 act as an active load. The common mode adjust circuitry 10 is used to compensate for any change in the common mode input voltage of the operational amplifier 11. As before, the differential outputs V_{Op} and V_{On} for the circuit are taken from the drains of n-channel transistors 3 and 4, respectively. As long as the common mode input voltage (V_{CMI} in Figure 3a) is kept equal to or appoximately equal to one transistor V_{GS} drop, this circuit can still be used as an operational amplifier. There are a number of applications where this circuit can be used, for example a fully differential switched-capacitor circuit often used in pipelined analog-to-digital converters, where there is little need for a high common-mode-rejection-ratio (CMRR) since all inputs and outputs are referenced to highly regulated internal bias voltages. This circuit requires a headroom which is 0.3V to 0.5 V smaller than the conventional long tail operational amplifier circuit of Figure 1. However, in a general sense, if the input common mode voltage is different from the desired value, the drain current of input transistors 1 and 2 can exhibit large variations from their nominal values. One simple solution to this problem is to increase the range of the output common mode adjustment circuitry 10 such that the current in transistors 8 and 9 can accommodate the current variation in input transistors 1 and 2 and make the necessary corrections. However, this can result in large undesirable variations in the amplifier bandwidth, making it desirable to have a more sophisticated, higher performance approach to the common mode input voltage correction problem.

Figure 3a is a schematic diagram for a switched-capacitor amplifier using the operational amplifier of the first embodiment of this invention. This circuit is chosen to illustrate the reasons why the common mode input voltage, V_{CMI}, changes. The circuit is comprised of the operational amplifier 11 of this invention, common mode adjust circuitry 10, four switched capacitors 12-15, phase 1 switches 16-21, and phase 2 switches 22-25, and has differential inputs Vᵢₚ and Vᵢₙ and differential outputs Vₒₚ and Vₒₙ. A clock cycle, consisting of phase 1 (p₁) sampling phase and phase 2 (p₂) amplification phase, for the circuit is shown in Figure 3b. The operation of the circuit is as follows. During phase 1, when p₁ switches 16-21 are closed, the top plates of all capacitors 12-15 (C₁ - C₄ ) are connected to the input common mode voltage V_{CMI}, whereas the bottom plates of capacitors 12 and 13 (C₁and C₂) are connected to Vᵢₚ and Vᵢₙ, respectively, and the bottom plates of capacitors 14 and 15 (C₃ and C₄) are connected to the output common mode voltage V_{CMO}. Ideally, the common voltage of Vᵢₚ and Vᵢₙ would be the same as V_{CMO}, as a result of the common mode feedback circuit of the previous stage. Then during phase 2, the bottom plates of capacitors 14 and 15 (C₃ and C₄) are connected to outputs Vₒₚ and Vₒₙ, respectively, while the bottom plates of capacitors 12 and 13 (C₁and C₂) are connected to V_{CMO}. Again, under ideal conditions, the common mode voltage at the amplifier input would be unchanged from phase 1 to phase 2. However, in practice the common mode voltages of Vᵢₚ, Vᵢₙ and Vₒₚ, Vₒₙ are different from V_{CMO} due to the non-idealities in the common mode feedback circuit of the preceding stage. This results in a change in the common mode input voltage of the amplifier during phase 2.

Another possible source of error is that of signal feed-through from the switches that are used for connecting the amplifier input nodes to V_{CMI} during phase 1. This can result in a change in the input common mode voltage V_{CMI} during phase 2. The combination of all these error sources can cause the common mode input voltage to change on the order of several tens of millivolts, which in turn can cause the drain current in input transistors 1 and 2 to change by as much as 25%, or more.

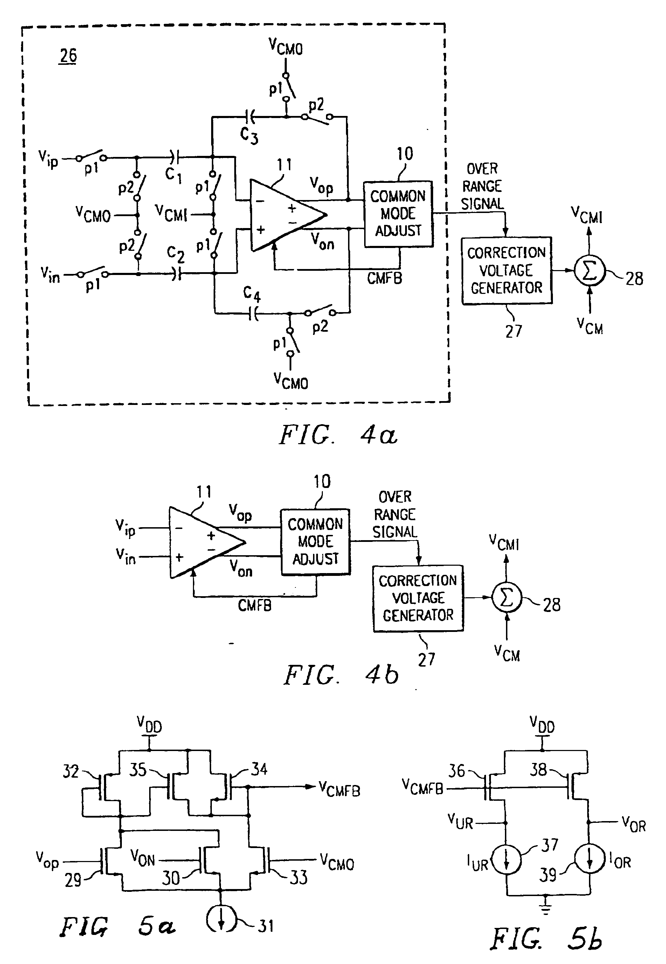

Figure 4 shows the method for correcting the common mode input voltage variations for this embodiment of the invention. Figure 4a illustrates this input common mode correction for the switched-capacitor amplifier 26 application discussed earlier, while Figure 4b shows this correction for a general-case amplifier application. In both cases (Figure 4a and Figure 4b) the amount of current supplied to amplifier 11 by the common mode feedback (CMFB) signal is monitored inside the common mode adjust circuit 10. Whenever this current exceeds a certain range, say ± 10% of the nominal amplifier bias current, an over-range or under-range signal is generated by the common mode adjust circuitry 10. This is then used to apply a suitable correction to the V_{CMI} voltage by means of a correction voltage generator 27 and summing circuit 28. This second correction feedback loop must be made slower that the main CMFB loop in order to avoid any signal 'chatter'.

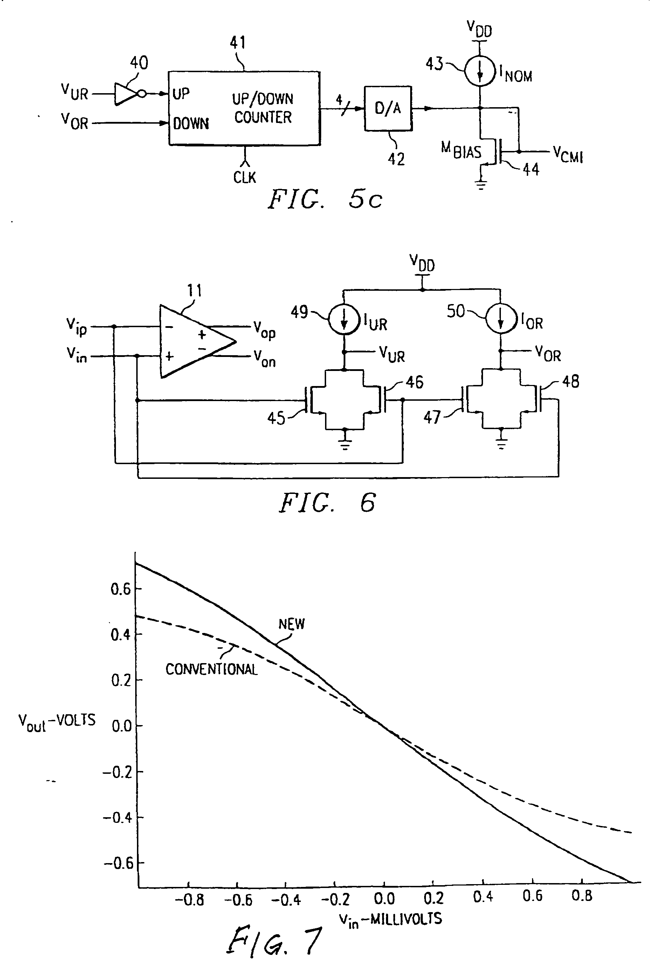

A first technique for correcting the common mode input voltage variations of this invention is shown in Figure 5. Figure 5a shows the common mode feedback circuit which generates the V_{CMFB} signal. This circuit is comprised on one side of two n-channel transistors 29-30 for input signals V_{OP} and V_{ON}, respectively, a current source 31, and a diode connected p-channel transistor 32. The other side of the circuit is comprised of a n-channel transistor 33 for the V_{CMO} input signal, a diode connected n-channel transistor 34, and the same current source 31. Another p-channel transistor 35 couples the two sides of the circuit together. The inputs to the circuit are V_{OP}, V_{ON}, and V_{CMO} and the output is V_{CMFB}.

The circuit of Figure 5b consists of two current mirrors, each comprised of a p-channel transistor 36 and/or 38 and a current source 37 and/or 39. This circuit monitors the V_{CMFB} signal and generates two replicas of the common mode current supplied to the main amplifier. These currents are then compared with a lower current limit I_{UR} and a higher current limit I_{OR}, flowing in constant current sources 37 and 39, respectively. If the current in the I_{OR} leg of the circuit exceeds the constant current I_{OR}, then the V_{OR} output signal will go high (UP). Likewise, if the current in the I_{UR} leg of the circuit is less than the constant current I_{UR}, then the V_{UR} output signal will go low (DOWN).

These V_{OR} and V_{UR} signals are then fed into the correction circuitry of Figure 5c. In this circuit, the V_{UR} signal is complemented by means of an inverter 40 and fed into the UP input of an UP/DOWN counter 41, while the V_{OR} signal is feed into the DOWN input of the same UP/DOWN counter 41. The counter 41 drives a low resolution (3-to-4 bits) digital-to-analog (D/A) converter 42 which generates a small correction current that is added to or subtracted from the current flowing in current source 43, which represents the nominal amplifier bias current. This total current is fed into a diode connected n-channel (M_{BIAS}) transistor 44 that is matched with the input transistors 1 and 2 of the main amplifier 11, shown in Figure 2. In operation, the operational amplifier's output signals V_{OP} and V_{ON} are compared with the common mode output voltage V_{CMO} and an appropriate common mode feedback signal V_{CMFB} is generated. Any change in the V_{CMFB} signal is reflected at the output of the current mirrors as an increase or decrease in the V_{OR} and V_{UR} signals, respectively. These V_{OR} and V_{UR} signals are then used to make the counter count clock pulsed either UP or DOWN. Finally, the output of the counter is converted back to an analog current and is added to or subtracted from the amplifier's nominal current and used to adjust the V_{CMI} voltage, such as to maintain common mode between the operational amplifier's input and output signals. In practice, the circuitry associated with this correction implementation can be realized with a small amount of extra chip area and a negligible amount of power. The combination of the UP/DOWN counter and D/A converter can also be implemented using a charge pump and a capacitor.

A second technique for implementing the control loop for the common mode input voltage correction of this invention is shown in Figure 6. Here, the combinations of two n-channel transistors pairs 45-46 and 47-48 are used to replicate the current flowing in the input transistors 1 and 2 of the main amplifier 11. These are compared with reference currents I_{UR}, which is slightly smaller than the nominal current, and I_{OR}, which is slightly larger than the nominal current, that is flowing in the I_{UR} current source 49 and the I_{OR} current source 50, respectively. If the replicated current is outside of the established window for the I_{UR} and I_{OR} currents, a correction is applied to the V_{CMI} using the same UP/DOWN counter circuit of Figure 5c.

Figure 7 compares the simulation results for both a conventional operational amplifier and the new operational amplifier of this patent, both running from a 2.5 volt power supply. As shown, for a given input signal, a several tenths of volt improvement in the output amplitude is realized, making it a desired circuit for low voltage applications.

While this invention has been described in the context of a preferred embodiment, it will be apparent to those skilled in the art that the present invention may be modified in numerous ways and may assume many embodiments other than that specifically set out and described above.

## Claims

1. A differential operational amplifier for operation between a first and a second voltage supply, comprising:
a differential pair of cascoded (3,4) input transistors (1,2) including first input transistor gates for receiving first and second input signals (Vip, Vin),
cascoded (6,7) active transistor loads (8,9) for connecting output nodes of each of said input transistor cascodes (3,4) to the second voltage supply, and
a common mode adjust circuit (10) connected to adjust the currents in the active transistor loads (8,9) in accordance with the common mode output signal from the output nodes (Vop, Von) of the differential pair of cascoded (3,4) input transistors (1,2), wherein
in the operation of the amplifier, second input (source) nodes of said cascoded input transistors (1,2) are coupled directly to the first voltage supply.

2. An amplifier as claimed in claim 1, further including a correction voltage generator (27) connected to the common mode adjust circuit (10) to adjust a common mode voltage of the first and second input signals (Vip, Vin).

3. An amplifier as claimed in claim 1 or 2, including field effect transistors in the differential pair of cascoded (3,4) input transistors (1,2), the source terminals of the lower (1,2) field effect transistors below the cascades (3,4) serving as the second input nodes and being, in operation, connected directly to the first voltage supply.

4. An amplifier as claimed in any of claims 1 to 3, wherein the difference between the first voltage supply and second voltage supply is less than 2.5 volts.

5. An amplifier as claimed in any one of claims 1 to 4, comprising:
a first n-channel transistor (1) including an input gate terminal for receiving a first input signal (Vip),
a second n-channel transistor (2) including an input gate for receiving a second input signal (Vin),
the source terminals of said first and second n-channel transistors being connected together and, in operation, connected to the first voltage supply,
a third n-channel transistor (3) including a source terminal to which the drain terminal of said first n-channel transistor is coupled,
a fourth n-channel transistor (4) including a source terminal to which the drain of said second n-channel transistor is coupled,
the gate terminals of said third and fourth n-channel transistors being connected together and for receiving a first common mode control signal (VB2),
a first p-channel transistor (6) including a drain terminal to which the drain terminal of said third n-channel transistor (3) and a first input of said common mode adjust circuit are connected, the drain terminals of the transistors serving as a first differential signal output terminal (Vop),
a second p-channel transistor (7) including a drain terminal to which the drain terminal of said fourth n-channel transistor and a second input of said common mode adjust circuit are connected, the drain terminals of the transistors serving as a second differential signal output terminal(Von),
the gate terminals of said first and second p-channel transistors being connected together for receiving a second common mode control signal (VB3),
a third p-channel transistor (8) including a drain terminal to which the source terminal of said first p-channel transistor is connected,
a fourth p-channel transistor (9) including a drain terminal to which the source terminal of said second p-channel transistor is connected,
the gate terminals of said third and fourth p-channel transistors connected together for receiving a first output signal (CMFB) from said common mode adjust circuit (10),
the source terminals of said third and fourth p-channel connected together for connection to the second voltage supply and
a second output terminal of said common mode adjust circuit (10) providing an over-range voltage output signal.

6. An operational amplifier as claimed in any one of claims 1 to 4, further comprising:
a correction voltage generator circuit (27) and
a summing amplifier circuit (28) together arranged to monitor the common mode output signal from the common mode adjust circuit and the amplifier being capable of:
monitoring the common mode output signal,
comparing the common mode output signal to a specified range around said amplifier's nominal bias current,
generating an out-of-range error signal when the monitored output signal is above or below said specified range, and
making with the correction voltage generator circuit (27) and the summing amplifier circuit an appropriate correction to the operational amplifier's common mode input voltage when said specified range is exceeded.

7. An amplifier as claimed in claim 6, wherein:
an input terminal of said correction voltage generator (27) is coupled to an output terminal of said common mode adjust circuit(10),
an output of said correction voltage generator is coupled to a first input of said summing amplifier,
a second input to said summing amplifier is coupled to a common mode voltage and
an output of said summing amplifier provides the corrected common mode input voltage to said amplifier.

8. An amplifier as claimed in any one of claims 1 to 4, including an UP/DOWN counter (41), a digital-to-analog converter (42), and summing circuitry (28) to develop a small correction current which is summed to the nominal amplifier bias current, further comprising:
an under range input voltage coupled to the input of an inverter (40);
the output of said inverter (40) being coupled to the first input of an UP/DOWN counter;
an over range input voltage coupled to the second input of said UP/DOWN counter;
a clock signal (CLK) coupled to the third input of said UP/DOWN counter;
the output of said UP/DOWN counter being coupled to the input of a digital-to-analog (D/A) converter;
the output of said D/A converter being coupled to the gate and drain of a n-channel transistor (44), to the output of a current source (43), and to the input common mode voltage output (VCMI);
the input of said current source being coupled to the power supply voltage (VDD);
the source of said n-channel transistor (44) being coupled to circuit ground.

9. An amplifier as claimed in claim 8, including a charge pump circuit and a capacitor in place of the combination of said UP/DOWN counter and digital-to-analog converter.

10. An amplifier as claimed in claim 6, which is operable to replicate the current flowing in the input transistors of the main operational amplifier (11) and generates UP and DOWN counter control signals by comparing replica currents to the upper and lower current limits, comprising:
a positive differential input signal coupled to the negative input of said operational amplifier (11) of this patent and to the gates of a first (46) and a second (47) n-channel transistor;
a negative differential input signal coupled to the positive input of said operational amplifier (11) and to the gates of a third (45) and a fourth (48) n-channel transistor;
the sources of said first and third n-channel transistors being connected together and coupled to circuit ground;
the sources of said second and fourth n-channel transistors being connected together and coupled to circuit ground;
the drains of said first and third n-channel transistors being connected together and coupled to the output of a first current source (49) and to an under range voltage output;
the drains of said second and fourth n-channel transistors being connected together and coupled to the output of a second current source (50) and to an over range voltage output;
the inputs to said first and second current sources being connected together and coupled to the power supply source (VDD).

11. An amplifier as claimed in any preceding claim connected to a network of capacitors and switches in a switched capacitor amplifier (26).

12. The switched capacitor amplifier (26) as claimed in claim 11, further comprising:
said first differential input signal (Vip) coupled to the input of a first phase 1 switch (p1);
said second differential input signal (Vin) coupled to the input of a second phase 1 switch(p1);
the output of said first phase 1 switch coupled to the input of a first phase 2 switch (p2) and to the bottom plate of a first capacitor (C1);
the output of said second phase 1(p1) switch coupled to the input of a second phase 2 switch and to the bottom plate of a second capacitor (C2);
the outputs of said first and second phase 1 switches connected together and coupled to the common mode output voltage (VCMO);
the top plate of said first capacitor coupled to top plate of a third capacitor (C3), to the input of a third phase 1 switch (p1), and to the negative input of said operational amplifier (11);
the top plate of said second capacitor(C2) coupled to the top plate of a fourth capacitor (C4), to the input of a fourth phase 1 switch, and to the positive input of said operational amplifier;
the outputs of said third and fourth phase 1 switches connected together and coupled to the input common mode voltage (VCMI);
the bottom plate of said third capacitor coupled to input of a third phase 2 switch and to the input of a fifth phase 1 switch;
the bottom plate of said fourth capacitor coupled to input of a fourth phase 2 switch and to the input of a sixth phase 1 switch;
the output of said fifth and sixth phase 1 switches coupled to the output common mode voltage;
the positive differential output of said operational amplifier coupled to the output of said third phase 2 switch and to the first input of common mode adjust circuit(10);
the negative differential output of said operational amplifier coupled to the output of said fourth phase 2 switch and to the second input of said common mode adjust circuit;
the first output of said common mode adjust circuit coupled to the third input of said operational amplifier;
the second output of said common mode adjust circuit providing an over range voltage used for the common mode correction.

13. A method for operating an operational amplifier with common mode input correction voltage, comprising:
amplifiying a signal with a telescopic cascoded differential amplifier free of a long tail current source;
generating a common mode feedback signal in accordance with the common mode output signal;
monitoring the amount of current supplied to said operational amplifier by said common mode feedback signal;
generating a value of said common mode input correction voltage based on how much the said amount of current exceeds a nominal amplifier bias current.

14. A method as claimed in claim 13 further comprising the steps of:
replicating the current flowing in the input transistors of the main operational amplifier and generates UP and DOWN counter control signals by comparing replica currents to the upper and lower current limits;
providing a corrected input common mode voltage using an UP/DOWN counter, a digital-to-analog converter, and summing circuitry to develop a small correction current which is summed to the nominal amplifier bias current.

## Patentansprüche

1. Differentieller Operationsverstärker für den Betrieb zwischen einer ersten und einer zweiten Spannungsversorgung, mit:
einem differentiellen Paar von als Kaskode (3, 4) geschalteten Eingangstransistoren (1, 2), die erste Eingangstransistor-Gates enthalten, um ein erstes und ein zweites Eingangssignal (Vip, Vin) zu empfangen,
als Kaskode (6, 7) geschalteten aktiven Transistorlasten (8, 9), um Ausgangsknoten jeder der Eingangstransistor-Kaskoden (3, 4) mit der zweiten Spannungsversorgung zu verbinden, und
einer Gleichtakteinstellschaltung (10), die so angeschlossen ist, dass sie die Ströme in den aktiven Transistorlasten (8, 9) in Übereinstimmung mit dem Gleichtaktausgangssignal von den Ausgangsknoten (Vop, Von) des differentiellen Paars von als Kaskode (3, 4) geschalteten Eingangstransistoren (1, 2) einstellt, wobei
im Betrieb des Verstärkers zweite Eingangsknoten (Source-Knoten) der als Kaskode geschalteten Eingangstransistoren (1, 2) direkt mit der ersten Spannungsversorgung gekoppelt sind.

2. Verstärker nach Anspruch 1, der ferner einen Korrekturspannungsgenerator (27) umfasst, der mit der Gleichtakteinstellschaltung (10) verbunden ist, um die Gleichtaktspannung des ersten und des zweiten Eingangssignals (Vip, Vin) einzustellen.

3. Verstärker nach Anspruch 1 oder 2, der Feldeffekttransistoren in dem differentiellen Paar von als Kaskode (3, 4) geschalteten Eingangstransistoren (1, 2) enthält, wobei die Source-Anschlüsse der unteren (1, 2) Feldeffekttransistoren unter den Kaskaden (3, 4) als die zweiten Eingangsknoten dienen und im Betrieb direkt mit der ersten Spannungsversorgung verbunden sind.

4. Verstärker nach einem der Ansprüche 1 bis 3, wobei die Differenz zwischen der ersten Spannungsversorgung und der zweiten Spannungsversorgung weniger als 2,5 Volt beträgt.

5. Verstärker nach einem der Ansprüche 1 bis 4, mit:
einem ersten n-Kanal-Transistor (1), der einen Eingangs-Gate-Anschluss enthält, um ein erstes Eingangssignal (Vip) zu empfangen,
einem zweiten n-Kanal-Transistor (2), der ein Eingangs-Gate enthält, um ein zweites Eingangssignal (Vin) zu empfangen,
wobei die Source-Anschlüsse des ersten und des zweiten n-Kanal-Transistors miteinander verbunden sind und im Betrieb mit der ersten Spannungsversorgung verbunden sind,
einem dritten n-Kanal-Transistor (3), der einen Source-Anschluss enthält, mit dem der Drain-Anschluss des ersten n-Kanal-Transistors gekoppelt ist,
einem vierten n-Kanal-Transistor (4), der einen Source-Anschluss enthält, mit dem der Drain des zweiten n-Kanal-Transistors gekoppelt ist,
wobei die Gate-Anschlüsse des dritten und des vierten n-Kanal-Transistors miteinander verbunden sind und dazu ausgelegt sind, ein erstes Gleichtaktsteuersignal (VB2) zu empfangen,
einem ersten p-Kanal-Transistor (6), der einen Drain-Anschluss enthält, mit dem der Drain-Anschluss des dritten n-Kanal-Transistors (3) und ein erster Eingang der Gleichtakteinstelischaltung verbunden sind, wobei die Drain-Anschlüsse der Transistoren als Ausgangsanschluss für ein erstes differentielles Signal (Vop) dienen,
einem zweiten p-Kanal-Transistor (7), der einen Drain-Anschluss enthält, mit dem der Drain-Anschluss des vierten n-Kanal-Transistors und ein zweiter Eingang der Gleichtakteinstelischaltung verbunden sind, wobei die Drain-Anschlüsse der Transistoren als Ausgangsanschluss für ein zweites differentielles Signal (Von) dienen,
wobei die Gate-Anschlüsse des ersten und des zweiten p-Kanal-Transistors miteinander verbunden sind, um ein zweites Gleichtaktsteuersignal (VB3) zu empfangen,
einem dritten p-Kanal-Transistor (8), der einen Drain-Anschluss enthält, mit dem der Source-Anschluss des ersten p-Kanal-Transistors verbunden ist,
einem vierten p-Kanal-Transistor (9), der einen Drain-Anschluss enthält, mit dem der Source-Anschluss des zweiten p-Kanal-Transistors verbunden ist,
wobei die Gate-Anschlüsse des dritten und des vierten p-Kanal-Transistors miteinander verbunden sind, um ein erstes Ausgangssignal (CMFB) von der Gleichtakteinstellschaltung (10) zu empfangen,
wobei die Source-Anschlüsse des dritten und des vierten p-Kanal-Transistors miteinander verbunden sind, um mit der zweiten Spannungsversorgung verbunden zu werden, und
wobei ein zweiter Ausgangsanschluss der Gleichtakteinstellschaltung (10) ein Ausgangssignal mit einer den Bereich überschreitenden Spannung bereitstellt.

6. Operationsverstärker nach einem der Ansprüche 1 bis 4, ferner mit:
einer Korrekturspannungs-Generatorschaltung (27) und
einer Summationsverstärkerschaltung (28), die gemeinsam angeordnet sind, um das Gleichtakt-Ausgangssignal von der Gleichtakteinstellschaltung zu überwachen, wobei der Verstärker in der Lage ist:
das Gleichtakt-Ausgangssignal zu überwachen,
das Gleichtakt-Ausgangssignal mit einem bestimmten Bereich um den Nennvorstrom des Verstärkers zu vergleichen,
ein Fehlersignal bei Werten außerhalb des Bereichs zu erzeugen, wenn das überwachte Ausgangssignal oberhalb oder unterhalb des bestimmten Bereichs liegt, und
mit der Korrekturspannungs-Generatorschaltung (27) und der Summationsverstärkerschaltung eine geeignete Korrektur an der Gleichtakt-Eingangsspannung des Operationsverstärkers vorzunehmen, wenn der bestimmte Bereich überschritten wird.

7. Verstärker nach Anspruch 6, wobei:
ein Eingangsanschluss des Korrekturspannungs-Generators (27) mit einem Ausgangsanschluss der Gleichtakteinstellschaltung (10) gekoppelt ist,
ein Ausgang des Korrekturspannungs-Generators mit einem ersten Eingang des Summationsverstärkers gekoppelt ist,
ein zweiter Eingang in den Summationsverstärker mit einer Gleichtaktspannung gekoppelt ist und
ein Ausgang des Summationsverstärkers die korrigierte Gleichtakt-Eingangsspannung in den Verstärker bereitstellt.

8. Verstärker nach einem der Ansprüche 1 bis 4, der einen AUFWÄRTS/ABWÄRTS-Zähler (41), einen Digital/Analog-Umsetzer (42) und eine Summationsschaltungsanordnung (28) umfasst, um einen kleinen Korrekturstrom zu entwickeln, der zu dem Nennvorstrom des Verstärkers addiert wird, ferner mit:
einer den Bereich unterschreitenden Eingangsspannung, die mit dem Eingang eines Inverters (40) gekoppelt ist;
wobei der Ausgang des Inverters (40) mit dem ersten Eingang eines AUFWÄRTS/ABWÄRTS-Zählers gekoppelt ist;
einer den Bereich überschreitenden Eingangsspannung, die mit dem zweiten Eingang des AUFWÄRTS/ABWÄRTS-Zählers gekoppelt ist;
einem Taktsignal (CLK), das mit dem dritten Eingang des AUFWÄRTS/ABWÄRTS-Zählers gekoppelt ist;
wobei der Ausgang des AUFWÄRTS/ABWÄRTS-Zählers mit dem Eingang eines Digital/Analog-Umsetzers (D/A-Umsetzer) gekoppelt ist;
wobei der Ausgang des D/A-Umsetzers mit dem Gate und dem Drain eines n-Kanal-Transistors (44), mit dem Ausgang einer Stromquelle (43) und mit dem eingegebenen Gleichtakt-Spannungsausgang (VCMI) gekoppelt ist;
wobei der Eingang der Stromquelle mit der Stromversorgungsspannung (VDD) verbunden ist; und
wobei die Source des n-Kanal-Transistors (44) mit Schaltungsmasse verbunden ist.

9. Verstärker nach Anspruch 8, der statt der Kombination aus AUFWÄRTS/ABWÄRTS-Zähler und Digital/Analog-Umsetzer eine Ladungspumpenschaltung und einen Kondensator enthält.

10. Verstärker nach Anspruch 6, der betreibbar ist, um den in die Eingangstransistoren des Hauptoperationsverstärkers (11) fließenden Strom zu kopieren, und der AUFWÄRTS- und ABWÄRTS-Zähler-Steuersignale durch Vergleichen von Kopieströmen mit der oberen bzw. der unteren Stromgrenze erzeugt, mit:
einem positiven differentiellen Eingangssignal, das mit dem negativen Eingang des Operationsverstärkers (11) dieses Patents und mit den Gates eines ersten (46) und eines zweiten (47) n-Kanal-Transistors gekoppelt ist;
einem negativen differentiellen Eingangssignal, das mit dem positiven Eingang des Operationsverstärkers (11) und mit den Gates eines dritten (45) und eines vierten (48) n-Kanal-Transistors gekoppelt ist;
wobei die Sources des ersten und des dritten n-Kanal-Transistors miteinander und mit Schaltungsmasse verbunden sind;
wobei die Sources des zweiten und des vierten n-Kanal-Transistors miteinander und mit Schaltungsmasse verbunden sind;
wobei die Drains des ersten und des dritten n-Kanals miteinander verbunden sind und mit dem Ausgang einer ersten Stromquelle (49) und einem den Bereich unterschreitenden Spannungsausgang gekoppelt sind;
wobei die Drains des zweiten und des vierten n-Kanals-Transistors miteinander verbunden sind und mit dem Ausgang einer zweiten Stromquelle (50) und mit einem den Bereich überschreitenden Spannungsausgang gekoppelt sind;
wobei die Eingänge in die erste und in die zweite Stromquelle miteinander verbunden sind und mit der Stromversorgungsquelle (VDD) gekoppelt sind.

11. Verstärker nach einem vorhergehenden Anspruch, der mit einem Netzwerk von Kondensatoren verbunden ist und in einem Verstärker (26) mit geschalteten Kondensatoren schaltet.

12. Verstärker (26) mit geschalteten Kondensatoren (11), ferner mit:
einem ersten differentiellen Eingangssignal (Vip), das mit dem Eingang eines ersten Phase-1-Schalters (p1) gekoppelt ist;
einem zweiten differentiellen Eingangssignal (Vin), das mit dem Eingang eines zweiten Phase-1-Schaliers (p1) gekoppelt ist;
wobei der Ausgang des ersten Phase-1-Schalters mit dem Eingang eines ersten Phase-2-Schalters (p2) und mit der unteren Platte eines ersten Kondensators (C1) gekoppelt ist;
wobei der Ausgang des zweiten Phase-1-Schafters (p1) mit dem Eingang eines zweiten Phase-2-Schalters und mit der unteren Platte eines zweiten Kondensators (C2) gekoppelt ist;
wobei die Ausgänge des ersten und des zweiten Phase-1-Schalters miteinander verbunden sind und mit der Gleichtakt-Ausgangsspannung (VCMO) gekoppelt sind;
wobei die obere Platte des ersten Kondensators mit der oberen Platte eines dritten Kondensators (C3), mit dem Eingang eines dritten Phase-1-Schalters (p1) und mit dem negativen Eingang des Operationsverstärkers (11) gekoppelt ist;
wobei die obere Platte des zweiten Kondensators (C2) mit der oberen Platte eines vierten Kondensators (C4), mit dem Eingang eines vierten Phase-1-Schalters und mit dem positiven Eingang des Operationsverstärkers gekoppelt ist;
wobei die Ausgänge des dritten und des vierten Phase-1-Schalters miteinander verbunden sind und mit der eingehenden Gleichtaktspannung (VCMI) gekoppelt sind;
wobei die untere Platte des dritten Kondensators mit dem Eingang eines dritten Phase-2-Schalters und mit dem Eingang eines fünften Phase-1-Schalters gekoppelt ist;
wobei die untere Platte des vierten Kondensators mit dem Eingang eines vierten Phase-2-Schalters und mit dem Eingang eines sechsten Phase-1-Schalters gekoppelt ist;
wobei der Ausgang des fünften und des sechsten Phase-1-Schalters mit der ausgehenden Gleichtaktspannung gekoppelt ist;
wobei der positive differentielle Ausgang des Operationsverstärkers mit dem Ausgang des dritten Phase-2-Schalters und mit dem ersten Eingang der Gleichtakteinstellschaltung (10) gekoppelt ist;
wobei der negative differentielle Ausgang des Operationsverstärkers mit dem Ausgang des vierten Phase-2-Schalters und mit dem zweiten Eingang der Gleichtakteinstellschaltung gekoppelt ist;
wobei der erste Ausgang der Gleichtakteinstellschaltung mit dem dritten Eingang des Operationsverstärkers gekoppelt ist; und
wobei der zweite Ausgang der Gleichtakteinstellschaltung eine den Bereich überschreitende Spannung bereitstellt, die für die Gleichtaktkorrektur verwendet wird.

13. Verfahren zum Betreiben eines Operationsverstärkers mit einer Gleichtakt-Eingangskorrekturspannung, das umfasst:
Verstärken eines Signals mit einem als Kaskode geschalteten Teleskop-Differenzverstärker, der keine lange masseseitige Stromquelle besitzt;
Erzeugen eines Gleichtakt-Rückkopplungssignals in Übereinstimmung mit dem Gleichtakt-Ausgangssignal;
Überwachen des dem Operationsverstärker zugeführten Strombetrags durch das Gleichtakt-Rückkopplungssignal;
Erzeugen eines Wertes der Gleichtakt-Eingangskorrekturspannung auf der Grundlage des Betrags, um den der Strombetrag einen Nennvorstrom des Verstärkers übersteigt.

14. Verfahren nach Anspruch 13, das ferner die folgenden Schritte umfasst:
Kopieren des in die Eingangstransistoren des Hauptoperationsverstärkers fließenden Stroms und Erzeugen von AUFWÄRTS- und ABWÄRTS-Zähler-Steuersignalen durch Vergleichen von Kopieströmen mit der oberen und der unteren Stromgrenze;
Bereitstellen einer korrigierten eingehenden Gleichtaktspannung unter Verwendung eines AUFWÄRTS/ABWÄRTS-Zählers, eines Digital/Analog-Umsetzers und einer Summationsschaltungsanordnung, um einen kleinen Korrekturstrom zu entwickeln, der zu dem Nennvorstrom des Verstärkers addiert wird.

## Revendications

1. Amplificateur opérationnel différentiel destiné à fonctionner entre une première et une seconde tension d'alimentation, comprenant :
une paire différentielle de transistors d'entrée (1, 2) montés en cascode (3, 4) comprenant des premières grilles de transistor d'entrée de manière à recevoir des premier et deuxième signaux d'entrée (Vip, Vin),
des charges actives (8, 9) de transistor montées en cascode (6, 7) pour connecter les noeuds de sortie de chacun desdits transistors d'entrée montés en cascode (3, 4) à la seconde tension d'alimentation, et
un circuit de réglage de mode commun (10) connecté pour régler les courants dans les charges actives de transistor (8, 9) selon le signal de sortie de mode commun en provenance des noeuds de sortie (Vop, Von) de la paire différentielle de transistors d'entrée (1, 2) montés en cascode (3, 4), dans lequel :
lors du fonctionnement de l'amplificateur, les deuxièmes noeuds d'entrée (source) desdits transistors d'entrée montés en cascode (1, 2) sont couplés directement à la première tension d'alimentation.

2. Amplificateur selon la revendication 1, comprenant en outre un générateur de tension de correction (27) connecté au circuit de réglage de mode commun (10) pour régler une tension de mode commun des premier et deuxième signaux d'entrée (Vip, Vin).

3. Amplificateur selon la revendication 1 ou la revendication 2, comprenant des transistors à effet de champ dans la paire différentielle de transistors d'entrée (1, 2) montés en cascode (3, 4), les bornes de source des transistors à effet de champ inférieurs (1, 2) en dessous des cascades (3, 4) servant de deuxièmes noeuds d'entrée et étant, en fonctionnement, connectés directement à la première tension d'alimentation.

4. Amplificateur selon l'une quelconque des revendications 1 à 3, dans lequel la différence entre la première tension d'alimentation et la deuxième tension d'alimentation est inférieure à 2,5 volts.

5. Amplificateur selon l'une quelconque des revendications 1 à 4, comprenant :
un premier transistor à canal n (1) comprenant une borne de grille d'entrée pour recevoir un premier signal d'entrée (Vip),
un deuxième transistor à canal n (2) comprenant une grille d'entrée pour recevoir un deuxième signal d'entrée (Vin),
les bornes de source desdits premier et deuxième transistors à canal n étant connectées ensemble et, en fonctionnement, connectées à la première tension d'alimentation,
un troisième transistor à canal n (3) comprenant une borne de source à laquelle la borne de drain dudit premier transistor à canal n est couplée,
un quatrième transistor à canal n (4) comprenant une borne de source à laquelle le drain dudit deuxième transistor à canal n est couplée,
les bornes de grille desdits troisième et quatrième transistors à canal n étant connectées ensemble pour recevoir un premier signal de commande de mode commun (VB2),
un premier transistor à canal p (6) comprenant une borne de drain à laquelle la borne de drain dudit troisième transistor à canal n (3) et une première entrée dudit circuit de réglage de mode commun sont connectées, les bornes de drain des transistors servant de première borne de sortie du signal différentiel (Vop),
un deuxième transistor à canal p (7) comprenant une borne de drain à laquelle la borne de drain dudit quatrième transistor à canal n et une deuxième entrée dudit circuit de réglage de mode commun sont connectées, les bornes de drain des transistors servant de deuxième borne de sortie du signal différentiel (Von),
les bornes de grille desdits premier et deuxième transistors à canal p étant connectées ensemble pour recevoir un deuxième signal de commande de mode commun (VB3),
un troisième transistor à canal p (8) comprenant une borne de drain à laquelle la borne de source dudit premier transistor à canal p est couplée,
un quatrième transistor à canal p (9) comprenant une borne de drain à laquelle la borne de source dudit deuxième transistor à canal p est couplée,
les bornes de grille desdits troisième et quatrième transistors à canal p étant connectées ensemble pour recevoir un premier signal de sortie (CMFB) en provenance dudit circuit de réglage de mode commun (10),
les bornes de source desdits troisième et quatrième transistors à canal p étant connectées ensemble pour être reliées à la deuxième tension d'alimentation, et
une deuxième borne de sortie dudit circuit de réglage de mode commun (10) fournissant un signal de sortie de tension de dépassement positif.

6. Amplificateur opérationnel selon l'une quelconque des revendications 1 à 4, comprenant en outre :
un circuit générateur de tension de correction (27), et
un circuit amplificateur sommateur (28), agencés tous deux de manière à surveiller le signal de sortie de mode commun du circuit de réglage de mode commun, l'amplificateur étant capable de :
surveiller le signal de sortie de mode commun,
comparer le signal de sortie de mode commun à une plage spécifiée autour dudit courant de polarisation nominal de l'amplificateur,
générer un signal d'erreur de dépassement lorsque le signal de sortie surveillé se situe au dessus ou en dessous de ladite plage spécifiée, et
faire avec le circuit générateur de tension de correction (27) et le circuit amplificateur sommateur, une correction appropriée à la tension d'entrée de mode commun de l'amplificateur opérationnel lorsque ladite plage spécifiée est dépassée.

7. Amplificateur selon la revendication 6, dans lequel :
une borne d'entrée dudit générateur de tension de correction (27) est couplée à une borne de sortie dudit circuit de réglage de mode commun (10),
une sortie dudit générateur de tension de correction est couplée à une première entrée dudit amplificateur sommateur,
une deuxième entrée vers ledit amplificateur sommateur est couplée à une tension de mode commun, et
une sortie dudit amplificateur sommateur délivre la tension d'entrée de mode commun corrigée audit amplificateur.

8. Amplificateur selon l'une quelconque des revendications 1 à 4, comprenant un compteur / décompteur (41), un convertisseur numérique - analogique (42), et des circuits sommateurs (28) pour développer un petit courant de correction qui est ajouté au courant de polarisation nominal de l'amplificateur, comprenant en outre :
une tension d'entrée de dépassement négatif couplée à l'entrée d'un inverseur (40) ;
la sortie dudit inverseur (40) étant couplée à la première entrée d'un compteur / décompteur ;
une tension d'entrée de dépassement positif couplée à la deuxième entrée dudit compteur / décompteur ;
un signal d'horloge (CLK) couplé à la troisième entrée dudit compteur / décompteur ;
la sortie dudit compteur / décompteur étant couplée à l'entrée d'un convertisseur numérique - analogique (D / A) ;
la sortie dudit convertisseur D / A étant couplée à la grille et au drain d'un transistor à canal n (44), à la sortie d'une source de courant (43), et à la sortie de tension de mode commun d'entrée (VCMI) ;
l'entrée de ladite source de courant étant couplée à la tension d'alimentation (VDD) ;
la source dudit transistor à canal n (44) étant couplée à la masse du circuit.

9. Amplificateur selon la revendication 8, comprenant un circuit de pompe de charge et un condensateur au lieu de l'association dudit compteur / décompteur et dudit convertisseur numérique - analogique.

10. Amplificateur selon la revendication 6, qui est fonctionnel pour répliquer le courant qui circule dans les transistors d'entrée de l'amplificateur opérationnel principal (11) et qui génère les signaux de commande du compteur / décompteur en comparant les courants répliqués aux limites de courant supérieure et inférieure, comprenant :
un signal d'entrée différentiel positif couplé à l'entrée négative dudit amplificateur opérationnel (11) de ce brevet, et aux grilles d'un premier (46) et d'un deuxième (47) transistors à canal n ;
un signal d'entrée différentiel négatif couplé à l'entrée positive dudit amplificateur opérationnel (11) et aux grilles d'un troisième (45) et d'un quatrième (48) transistors à canal n ;
les sources desdits premier et troisième transistors à canal n étant connectées ensemble et couplées à la masse du circuit ;
les sources desdits deuxième et quatrième transistors à canal n étant connectées ensemble et couplées à la masse du circuit ;
les drains desdits premier et troisième transistors à canal n étant connectés ensemble et couplés à la sortie d'une première source de courant (49) et à une tension de sortie de dépassement négatif ;
les drains desdits deuxième et quatrième transistors à canal n étant connectés ensemble et couplés à la sortie d'une deuxième source de courant (50) et à une tension de sortie de dépassement positif ;
les entrées vers lesdites première et deuxième sources de courant étant connectées ensemble et couplées à la source d'alimentation (VDD).

11. Amplificateur selon l'une quelconque des revendications précédentes, connecté à un réseau de condensateurs et de commutateurs dans un amplificateur à capacités commutées (26).

12. Amplificateur à capacités commutées (26) selon la revendication 11, comprenant en outre le fait que :
ledit premier signal d'entrée différentiel (Vip) est couplé à l'entrée d'un premier commutateur de phase 1 (p1) ;
ledit deuxième signal d'entrée différentiel (Vin) est couplé à l'entrée d'un deuxième commutateur de phase 1 (p1) ;
la sortie dudit premier commutateur de phase 1 (p1) est couplée à l'entrée d'un premier commutateur de phase 2 (p2) et à la plaque inférieure d'un premier condensateur (C1) ;
la sortie dudit deuxième commutateur de phase 1 est couplée à l'entrée d'un deuxième commutateur de phase 2 et à la plaque inférieure d'un deuxième condensateur (C2) ;
les sorties desdits premier et deuxième commutateurs de phase 1 sont connectées ensemble et couplées à la tension de sortie de mode commun (VCMO) ;
la plaque supérieure dudit premier condensateur est couplée à la plaque supérieure d'un troisième condensateur (C3), à l'entrée d'un troisième commutateur de phase 1 (p1), et à l'entrée négative dudit amplificateur opérationnel (11) ;
la plaque supérieure dudit deuxième condensateur (C2) est couplée à la plaque supérieure d'un quatrième condensateur (C4), à l'entrée d'un quatrième commutateur de phase 1, et à l'entrée positive dudit amplificateur opérationnel ;
les sorties desdits troisième et quatrième commutateurs de phase 1 sont connectées ensemble et couplées à la tension d'entrée de mode commun (VCMI) ;
la plaque inférieure dudit troisième condensateur est couplée à l'entrée d'un troisième commutateur de phase 2 et à l'entrée d'un cinquième commutateur de phase 1 ;
la plaque inférieure dudit quatrième condensateur est couplée à l'entrée d'un quatrième commutateur de phase 2 et à l'entrée d'un sixième commutateur de phase 1 ;
la sortie desdits cinquième et sixième commutateurs de phase 1 est couplée à la tension de mode commun de sortie ;
la sortie différentielle positive dudit amplificateur opérationnel est couplée à la sortie dudit troisième commutateur de phase 2 et à la première entrée du circuit de réglage de mode commun (10) ;
la sortie différentielle négative dudit amplificateur opérationnel est couplée à la sortie dudit quatrième commutateur de phase 2 et à la deuxième entrée dudit circuit de réglage de mode commun ;
la première sortie dudit circuit de réglage de mode commun est couplée à la troisième entrée dudit amplificateur opérationnel ;
la deuxième sortie dudit circuit de réglage de mode commun fournissant une tension de dépassement positif utilisée pour la correction de mode commun.

13. Procédé d'actionnement d'un amplificateur opérationnel avec une tension de correction d'entrée de mode commun, comprenant les étapes consistant à :
amplifier un signal avec un amplificateur différentiel monté en cascode télescopique sans source de courant à longue queue ;
générer un signal de rétroaction de mode commun selon le signal de sortie de mode commun ;
surveiller la quantité de courant délivrée audit amplificateur opérationnel par ledit signal de rétroaction de mode commun ;
générer une valeur de ladite tension de correction de mode commun d'entrée sur la base de la grandeur dont ladite quantité de courant dépasse un courant de polarisation nominal de l'amplificateur.

14. Procédé selon la revendication 13, comprenant en outre les étapes consistant à :
répliquer le courant qui circule dans les transistors d'entrée de l'amplificateur opérationnel principal, et à générer les signaux de commande d'un compteur / décompteur en comparant les courants répliqués à des limites de courant supérieure et inférieure ;
fournir une tension de mode commun d'entrée corrigée en utilisant un compteur / décompteur, un convertisseur numérique - analogique, et des circuits sommateurs pour développer un petit courant de correction qui est ajouté au courant de polarisation nominal de l'amplificateur.
